# EUROPÄISCHE PATENTSCHRIFT

(11) **EP 2 440 884 B1**
(45) Veröffentlichungstag und Bekanntmachung des Hinweises auf die Patenterteilung: **19.04.2017**
(21) Anmeldenummer: 10715821.4
(22) Anmeldetag: 23.04.2010
(51) Int. Cl.: G01D 11/24, H05K 5/00

(54) **ELEKTRONISCHES BAUTEIL SOWIE VERFAHREN ZUR HERSTELLUNG DES ELEKTRONISCHEN BAUTEILS**
ELECTRONIC COMPONENT AND METHOD OF MANUFACTURING THE ELECTRONIC COMPONENT
COMPOSANT ÉLECTRONIQUE ET PROCÉDÉ DE FABRICATION DU COMPOSANT ÉLECTRONIQUE

(30) Priorität: 08.06.2009 DE 102009026806
(43) Veröffentlichungstag der Anmeldung: 18.04.2012
(73) Patentinhaber: Robert Bosch GmbH, 70442 Stuttgart (DE)
(72) Erfinder: LUDWIG, Ronny, 72411 Bodelshausen (DE)
(86) Internationale Anmeldenummer: PCT/EP2010/055460
(87) Internationale Veröffentlichungsnummer: WO 2010/142491

(56) Entgegenhaltungen:
- DE-A1- 19 928 917
- DE-A1- 19 948 613
- US-A1- 2005 014 411

## Beschreibung

### Stand der Technik

Die vorliegende Erfindung umfasst ein elektronisches Bauteil, insbesondere einen Beschleunigungssensor zur Anwendung in einem Kraftfahrzeug, mit einem Mikrobauteil kontaktiert und befestigt auf einem Trägerelement. Des Weiteren umfasst die Erfindung ein Blechstanzband zur Verwendung bei der Herstellung des elektronischen Bauteils sowie ein Verfahren zur Herstellung des elektronischen Bauteils.

Die Offenlegungsschrift DE 19948613 A1 offenbart ein elektromechanisches Bauteil mit einem Mikrobauteil kontaktiert und befestigt auf einem Trägerelement.

Bekannte Konzepte in der Aufbau- und Verbindungstechnik von Mikrobauteilen, insbesondere Sensoren, verwenden immer kleiner werdende und voll integrierte Lösungen zur Darstellung der Funktion. Gehäusekonzepte zur "Verpackung" von Sensorchips, z.B. "Land-Grid-Arrays" (LGA), integrieren sämtliche Bauelemente einer Schaltung in einem winzigen Gehäuse, welches nur wenige Kubikmillimeter umfasst. Derartige miniaturisierte Schaltungen stellen eine enorme Herausforderung für das sogenannte "Second-Level-Packaging", also die Weiterverarbeitung zu einem Sensor mit Befestigungsmöglichkeit und Stecker, dar. Da derartige miniaturisierte Schaltungen, wie z.B. LGA's, keine Leiterplatte oder anderweitige Schaltungsträger mehr benötigen, werden diese typischerweise direkt in umgebende Sensorgehäuse montiert. Typischerweise werden Mikrobauteile in Anordnungen nach dem Stand der Technik mit metallischen Trägerstreifen oder Trägerelementen kontaktiert. Zur Fixierung und Kontaktherstellung von Mikrobauelement und Trägerelement kommen dabei thermische Verbindungsprozesse wie Löten, leitfähiges Kleben oder Schweißen zur Anwendung. Bevorzugt wird der Lötprozess angewendet, welcher aber auch Risiken und Probleme birgt. So treten hier beispielsweise thermischer Stress auf den Verbindungsstellen, Lotkugeln, Lunker im Lot und nicht zuletzt organische Rückstände des Flussmittels auf. Diese organischen Rückstände können mit Silikon, verwendet als Gehäusewerkstoff, in Wechselwirkung treten. Ein weiteres Problem ist die beim Kontaktieren des Mikrobauteils auftretende Scherwirkung bzw. Scherkraft zwischen vorverzinnten Kontaktpads des Mikrobauteils und den metallischen Trägerstreifen oder Trägerelementen. Durch die Scherwirkung entstehen Beschädigungen in Form von Kratzern und es besteht das Risiko der Spanbildung. Da das Mikrobauteil, bedingt durch seine geringen Abmessungen, nur sehr geringe Abstände der potentialleitenden Mess- und Programmierpads aufweist, können schon kleinste metallisch leitende Partikel und Späne zum Kurzschluss führen.

### Offenbarung der Erfindung

Das erfindungsgemäße elektronische Bauteil mit den Merkmalen des Anspruchs 1 ermöglicht es ohne thermische Verbindungsprozesse wie Löten, Leitkleben oder Schweißen eine hohe Kontaktkraft zwischen Mikrobauteil und Trägerelement aufzubringen. Diese hohe Kontaktkraft ermöglicht sowohl das sichere Befestigen bzw. Fixieren des Mikrobauteils auf dem Trägerelement sowie den sicheren elektrischen bzw. elektronischen Kontakt zwischen Trägerelement und Mikrobauteil. Des Weiteren wird die Kontaktkraft reibungsfrei und somit ohne Beschädigung der Kontaktstellen übertragen, wodurch Kratzer und Spanbildung vermieden wird. Durch die Vermeidung der thermischen Montagemethode wird thermischer Stress auf das Mikrobauteil weitgehend vermieden. Des Weiteren findet dadurch keine Kontamination durch Lötkugeln, Flussmittelrückstände, Schmauchspuren, Kleberückstände beim Silberleitkleben oder Ähnliches statt. Ferner ist das elektronische Bauteil aus folgenden Gründen sehr kostengünstig herzustellen: Ein wesentlicher Grund für die kostengünstige Herstellung ist, dass die erfindungsgemäße Vorrichtung keiner Leiterplatte oder Substrat bedarf. Somit ist eine prozesssichere Verwendung eines miniaturisierten Mikrobauteils, insbesondere LGA-Gehäuses, möglich. Durch das Vermeiden der thermischen Verbindungsmethoden reduziert sich der Aufwand im Montageprozess. Diese Vermeidung der thermischen Verbindungsmethoden erhöht des Weiteren die Umweltfreundlichkeit des elektronischen Bauteils, da die Verwendung sämtlicher bleihaltiger Materialien vermieden wird. Letztendlich entsteht ein sehr preisgünstiges elektronisches Bauteil, welches insbesondere im Kraftfahrzeugbereich als Beschleunigungssensor, beispielsweise für Airbags, vorteilhafte Anwendung findet. All dies wird erreicht durch ein elektronisches Bauteil, umfassend zumindest ein Mikrobauteil, kontaktiert und befestigt auf einem Trägerelement, wobei das Trägerelement ein zur Befestigung des zumindest einen Mikrobauteils ausgebildetes Federelement umfasst, und wobei das Federelement mittels einer Rastvorrichtung im Trägerelement eingerastet ist, um das zumindest eine Mikrobauteil auf dem Trägerelement zu befestigen. Bevorzugt ist das Trägerelement sowohl für ein einzelnes Mikrobauteil als auch mehrere Mikrobauteile ausgelegt. Zur vereinfachten Darstellung wird im Folgenden die Variante mit einem Mikrobauteil dargestellt.

Die Unteransprüche zeigen bevorzugte Weiterbildungen der Erfindung.

In bevorzugter Ausgestaltung des erfindungsgemäßen elektronischen Bauteils ist vorgesehen, dass das Trägerelement und das Federelement integral, insbesondere aus gebogenem Blech, gefertigt sind. Das Trägerelement kann somit kostengünstig und einstückig produziert werden.

Erfindungsgemäß umfasst das Federelement einen Kontaktfederabschnitt, welcher zum Kontaktieren des Mikrobauteils und des Trägerelements ausgebildet ist. Der Kontakt zwischen dem Mikrobauteil, insbesondere den Kontaktpads des Mikrobauteils, und dem Trägerelement erfolgt somit über einen bestimmten Abschnitt, nämlich dem Kontaktfederabschnitt, des Federelements.

Erfindungsgemäß ist vorgesehen, dass das Trägerelement eine Mikrobauteilauflage umfasst, wobei die Mikrobauteilauflage in einen Hauptfederabschnitt des Federelementes übergeht, wobei der Hauptfederabschnitt in den Kontaktfederabschnitt übergeht, wobei das Federelement mit zumindest einer Rastnase der Rastvorrichtung endet, und wobei an der Mikrobauteilauflage eine Rastnut der Rastvorrichtung ausgebildet ist. Auf dieser Mikrobauteilauflage kommt das montierte Mikrobauteil zu liegen, wobei dabei vorteilhafterweise die Kontaktpads des Mikrobauteils dem Trägerelement verbunden. An einer Seite der Mikrobauteilauflage geht die Mikrobauteilauflage direkt in den Hauptfederabschnitt über, wohingegen auf der anderen Seite der Mikrobauteilauflage die Mikrobauteilauflage über die Rastvorrichtung mit dem Federelement verbunden ist.

In bevorzugter Ausführung ist vorgesehen, dass das Trägerelement zum Einsetzen des Mikrobauteils zwischen dem Kontaktfederabschnitt und der Mikrobauteilauflage ausgebildet ist, wobei der Kontaktfederabschnitt bogenförmig in Richtung der Mikrobauteilauflage ausgebildet ist. Diese Bogenform des Kontaktfederabschnitts bewirkt zum einen, dass dieser Kontaktfederabschnitt für sich elastisch ist und somit eine Art Feder darstellt. Des Weiteren liegt der Kontaktfederabschnitt dank der U-förmigen bzw. bogenförmigen Ausgestaltungen im Wesentlichen entlang einer Kontaktlinie auf dem Kontaktpad des Mikrobauteils auf, wodurch eine relativ große Kraft und somit ein relativ guter Kontakt zwischen Kontaktfederabschnitt und Kontaktpad erreicht wird. In weiterer vorteilhafter Ausgestaltung beaufschlagt der Hauptfederabschnitt den Kontaktfederabschnitt in einer Richtung entgegen der Einklemmung des Mikrobauteils und die Rastvorrichtung verhindert eine Bewegung des Kontaktfederabschnitts in Richtung entgegen dieser Einklemmung. D.h., der Hauptfederabschnitt hält das Federelement offen und somit beabstandet von der Mikrobauteilauflage, wohingegen die geschlossene Rastvorrichtung das Federelement in Richtung der Mikrobauteilauflage zieht und somit das Mikrobauteil eingeklemmt werden kann.

In weiterer vorteilhafter Ausgestaltung der Rastvorrichtung ist vorgesehen, dass zumindest eine Wandung der Rastnut und/oder die Rastnase elastisch verformbar sind. Dadurch wird ein leichtes Verschließen der Rastvorrichtung und somit ein einfacher Montageprozess gewährleistet.

In vorteilhafter Ausgestaltung umfasst das erfindungsgemäße elektronische Bauteil zwei voneinander getrennte Trägerelemente, wobei jedes der Trägerelemente ein Federelement und eine Rastvorrichtung umfasst, um das Mikrobauteil mittels beider Trägerelemente zu befestigen und zu kontaktieren. Sämtliche vorteilhaften Ausgestaltungen, die in Verbindung mit nur einem Trägerelement bereits beschrieben wurden oder noch beschrieben werden, sind selbstverständlich auch auf diese beiden Trägerelemente anwendbar, wobei vorteilhafterweise beide Trägerelemente exakt identisch ausgeführt sind, um die Anzahl unterschiedlicher Teile zu minimieren.

In weiterer vorteilhafter Ausgestaltung des elektronischen Bauteils mit zwei getrennten Trägerelementen ist vorgesehen, dass das Mikrobauteil zwei Kontaktpads umfasst, welche über je einen Kontaktfederabschnitt mit einem am Trägerelement ausgebildeten Anschlusspin verbunden sind. Dafür ist pro Trägerelement ein Anschlusspin ausgebildet. Durch die Anschlusspins ist es möglich, beispielsweise einen Anschlusskontakt zu einem Stecker oder einem Kabel herzustellen. Die Anschlusspins fungiert z.B. als Steckkontakt zum Anschluss des elektronischen Bauteils an ein Bus-System eines Kraftfahrzeugs.

In weiterer bevorzugter Ausführung umfasst das elektronische Bauteil einen ersten Kunststoffüberzug und einen zweiten Kunststoffüberzug, welche zusammen das Gehäuse bzw. das sogenannte "Second-Level-Packaging" bilden. Der erste Kunststoffüberzug kapselt das Mikrobauteil mit zumindest einem Teil des Trägerelements und/oder der Trägerelemente ein. Am zweiten Kunststoffüberzug sind Schnittstellen, insbesondere Befestigungsformelemente und Anschlussformelemente, zur Anbindung des elektronischen Bauteils ausgebildet. Vorteilhaftes Material des ersten Kunststoffüberzugs ist Silikon und des zweiten Kunststoffüberzugs ein Thermoplast. Das vorteilhaft zu verwendende Fertigungsverfahren ist ein Zweikomponenten-Spritzgießverfahren, bei dem das mit zumindest einem Trägerelement verbundene Mikrobauteil zuerst mit einem relativ weichen Material, z.B. Silikon, in einem ersten Schritt umspritzt wird. Dieses Konstrukt aus erstem Kunststoffüberzug, Mikrobauteil und Trägerelement wird in einem zweiten Schritt mittels Spritzgießverfahren mit einem Gehäusekunststoff, insbesondere Thermoplast, umspritzt. Durch dieses Zweikomponenten-Umspritzen lässt sich der zweite Kunststoffüberzug in beliebiger Form kundenindividuell gestalten. Dadurch lassen sich kundenindividuelle Stecksysteme zur Anbindung des erfindungsgemäßen elektronischen Bauteils an Schnittstellen des Kunden ausgestalten. Da insbesondere bei Umspritzen des zweiten Kunststoffüberzugs relativ hohe Drücke verwendet werden, ist es besonders vorteilhaft, einen relativ weichen ersten Kunststoffüberzug zu verwenden, um das empfindliche Mikrobauteil vor zu hohem Stress zu bewahren.

Die Erfindung umfasst des Weiteren einen Sensor mit den Merkmalen des Anspruchs 8, insbesondere einen Beschleunigungssensor, zur Anwendung in einem Kraftfahrzeug, umfassend ein soeben beschriebenes elektronisches Bauteil, wobei das Mikrobauteil einen mikroelektromechanischen Sensor umfasst. Die im Rahmen des erfindungsgemäßen elektronischen Bauteils diskutierten vorteilhaften Ausgestaltungen finden selbstverständlich auch entsprechende Anwendung für den erfindungsgemäßen Sensor zur Anwendung im Kraftfahrzeug.

Ferner umfasst die Erfindung ein Blechstanzband, ausgebildet zur Verwendung bei der Herstellung des soeben diskutierten elektronischen Bauteils, wobei mehrere Trägerelemente, umfassend ein Federelement und eine Rastvorrichtung mittels abstanzbarer Verbindungsbereiche miteinander verbunden sind. Es sind also eine Vielzahl der Trägerelemente nebeneinander in einem Stanzband angeordnet und können durch einen Stanzprozess voneinander getrennt werden. Die bereits diskutierten vorteilhaften Ausgestaltungen der Trägerelemente finden sich in entsprechender Form im erfindungsgemäßen Stanzband wieder. Die Form des gesamten Trägerelements lässt vorteilhafterweise eine Anordnung in solch einem erfindungsgemäßen Blechstanzband zu. Dadurch sind vorteilhafterweise Galvanikprozesse in einer Bandgalvanik-Anlage möglich.

Des Weiteren umfasst die Erfindung ein Verfahren mit den Merkmalen des Anspruchs 9 zur Herstellung eines elektronischen Bauteils nach einem der Ansprüche 1 bis 7, insbesondere eines Beschleunigungssensors zur Anwendung in einem Kraftfahrzeug, umfassend die folgenden Schritte: Bereitstellen eines Trägerelements mit einem zur Befestigung eines Mikrobauteils ausgebildeten Federelements, Einsetzen des Mikrobauteils zwischen einem Kontaktfederabschnitt des Federelements und eine Mikrobauteilauflage des Trägerelements, Schließen des Federelements entgegen einer Federkraft und Einrasten einer Rastvorrichtung zwischen Federelement und Trägerelement. Die Federkraft, gegen welche geschlossen wird, entsteht vorteilhafterweise in einem Hauptfederabschnitt des Federelements. Die bereits diskutierten vorteilhaften Ausgestaltungen des erfindungsgemäßen elektronischen Bauteils sowie des erfindungsgemäßen Blechstanzbandes finden selbstverständlich entsprechende Anwendung in
Verbindung mit dem erfindungsgemäßen Verfahren zur Herstellung des elektronischen Bauteils.

### Kurze Beschreibung der Zeichnung

Nachfolgend werden zwei Ausführungsbeispiele der Erfindung unter Bezugnahme auf die begleitende Zeichnung im Detail beschrieben. Dabei zeigt:
- Figur 1: drei Ansichten in teilweiser Durchsicht des fertigen erfindungsgemäßen elektronischen Bauteils gemäß einem ersten Ausführungsbeispiel,
- Figur 2: eine Unteransicht sowie zwei Seitenansichten eines Mikrobauteils gemäß dem ersten Ausführungsbeispiel,
- Figur 3: eine mögliche Anordnung elektronischer Bauteile innerhalb des Mikrobauteils gemäß dem ersten Ausführungsbeispiel,
- Figur 4: eine Draufsicht auf zwei Trägerelemente gemäß dem ersten Ausführungsbeispiel,
- Figur 5: eine Seitenansicht eines Trägerelements gemäß dem ersten Ausführungsbeispiel,
- Figur 6: eine Frontansicht beider Trägerelemente gemäß dem ersten Ausführungsbeispiel,
- Figur 7: einen schematischen Ablauf der Einrastung einer Rastvorrichtung gemäß dem ersten Ausführungsbeispiel,
- Figur 8: eine Montage des Mikrobauteils in die beiden Trägerelemente gemäß dem ersten Ausführungsbeispiel,
- Figur 9: eine Seitenansicht des Trägerelements nebst positioniertem Mikrobauteil gemäß dem ersten Ausführungsbeispiel,
- Figur 10: eine Frontansicht beider Trägerelemente mit positioniertem Mikrobauteil gemäß dem ersten Ausführungsbeispiel,
- Figur 11: eine Seitenansicht eines Trägerelements mit verschlossener Rastvorrichtung gemäß dem ersten Ausführungsbeispiel,
- Figur 12: eine Frontansicht beider Trägerelemente mit verschlossener Rastvorrichtung gemäß dem ersten Ausführungsbeispiel,
- Figur 13: eine Schnittansicht beider Trägerelemente mit verschlossener Rastvorrichtung gemäß dem ersten Ausführungsbeispiel,
- Figur 14: drei Ansichten des erfindungsgemäßen elektronischen Bauteils nach dem ersten Ausführungsbeispiel mit einem ersten Kunststoffüberzug,
- Figur 15: ein Stanzband zur Herstellung der Trägerelemente gemäß dem ersten Ausführungsbeispiel,
- Figur 16: eine Frontansicht des Stanzbandes gemäß dem ersten Ausführungsbeispiel,
- Figur 17: eine Montage des Mikrobauteils in zwei Trägerelemente gemäß einem zweiten Ausführungsbeispiel, und
- Figur 18: eine Frontansicht der zweier Trägerelemente des zweiten Ausführungsbeispiels.

### Ausführungsformen der Erfindung

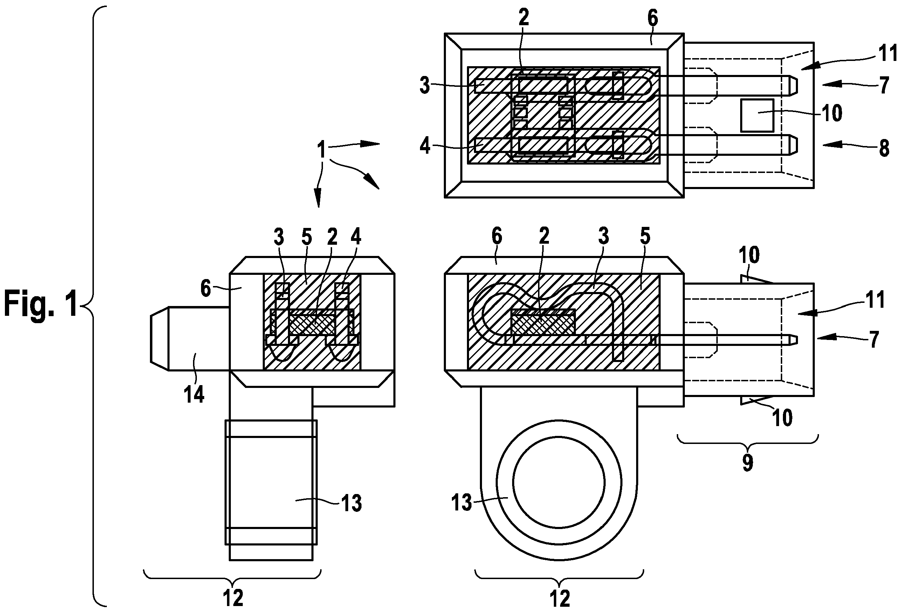

Die Figuren 1 bis 16 zeigen ein elektronisches Bauteil in unterschiedlichen Verfahrens- bzw. Herstellungsschritten gemäß einem ersten Ausführungsbeispiel.

Dabei zeigt Figur 1 drei Ansichten in teilweiser Durchsicht bzw. teilweiser Schnittansicht eines elektronischen Bauteils 1. Dieses elektronische Bauteil 1 besteht aus einem Mikrobauteil 2, einem ersten Trägerelement 3, einem zweiten Trägerelement 4, einem ersten Kunststoffüberzug 5 und einem zweiten Kunststoffüberzug 6. Das Mikrobauteil 2 ist dabei in das erste Trägerelement 3 und das zweite Trägerelement 4 eingeklemmt und mit diesem kontaktiert. Das gesamte Mikrobauteil 2 sowie ein Teil des ersten Trägerelementes 3 und des zweiten Trägerelementes 4 sind mit dem ersten Kunststoffüberzug 5, bestehend aus Silikon und dem zweiten Kunststoffüberzug 6, bestehend aus einem Thermoplast, umhüllt. Dabei bleibt ein erster Anschlusspin 7 des ersten Trägerelementes 3 und ein zweiter Anschlusspin 8 des zweiten Trägerelementes 4 frei sowohl vom ersten Kunststoffüberzug 5 als auch vom zweiten Kunststoffüberzug 6, so dass über den ersten Anschlusspin 7 und den zweiten Anschlusspin 8 eine Kontaktierung des gesamten elektronischen Bauteils mit einem Stecker bzw. einem Kabel, beispielsweise zu einem Fahrzeugbus-System, möglich ist.

Insbesondere zur kundenindividuellen Ausgestaltung umfasst der zweite Kunststoffüberzug 6 ein Anschlussformelement 9, ausgebildet als Steckkontakt sowie ein Befestigungsformelement 12. Dieses Anschlussformelement 9 und dieses Befestigungsformelement 12 stellen Schnittstellen des elektronischen Bauteils 1 dar. Das Anschlussformelement 9 umfasst einen Hohlraum 11. In diesen Hohlraum 11 ragen der erste Anschlusspin 7 sowie der zweite Anschlusspin 8. Des Weiteren umfasst das Anschlussformelement 9 eine Steckersicherung 10 an seiner Außenseite. Diese Steckersicherung 10 ermöglicht beispielsweise eine Rastverbindung mit einem Stecker.

Das Befestigungsformelement 12 umfasst eine umspritzte Buchse 13 sowie eine Verdrehsicherung 14. Die umspritzte Buchse 13 ist ein Metalleinlegeteil, welches bei Aufbringen des zweiten Kunststoffüberzuges 6 mit umspritzt wurde und stellt eine Anschraubmöglichkeit an beispielsweise eine Schnittstelle im Kraftfahrzeug dar. Die Verdrehsicherung 14, ausgebildet als Zapfen, erstreckt sich in Richtung einer Mittenachse der umspritzten Buchse 13 und ermöglicht somit die drehsichere Anbringung des elektronischen Bauteils 1 mit nur einer Schraube bzw. mit nur einem Bolzen.

Wie bereits in Figur 1 erkennbar ist, ist nicht in jeder Ansicht das erste Trägerelement 3 als auch das zweite Trägerelement 4 zu sehen. Es bleibt jedoch zu beachten, dass unabhängig davon, ob beide Trägerelemente 3, 4 dargestellt sind oder nicht, die beiden Trägerelemente des elektronischen Bauteils 1 vollkommen identisch sind. So wird im Folgenden manche Ausgestaltung der Trägerelemente lediglich anhand des ersten Trägerelementes 3 beschrieben. Die Ausgestaltungen des ersten Trägerelementes 3 treffen jedoch in gleicher Weise auf das zweite Trägerelement 4 zu.

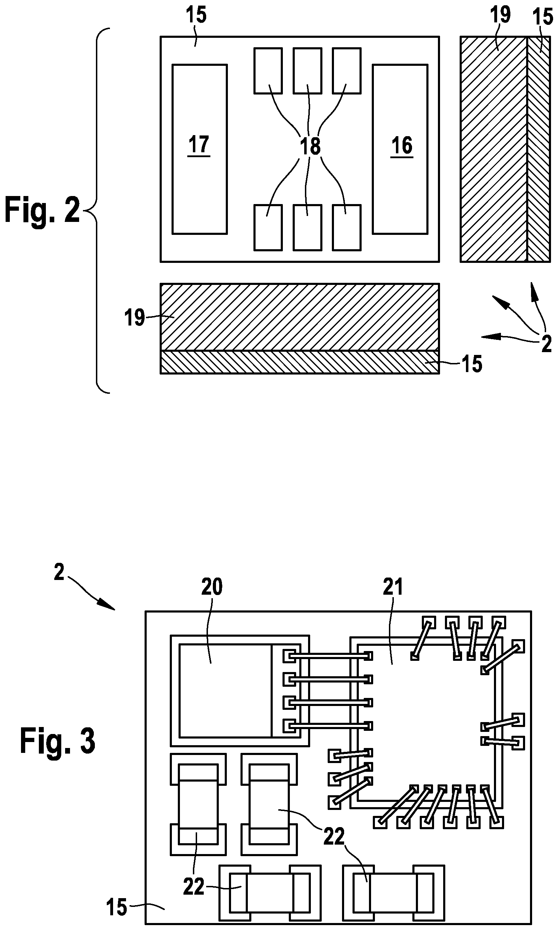

Figur 2 zeigt das Mikrobauteil 2, ausgebildet als LGA-Package, wie es in dem elektronischen Bauteil 1 gemäß dem ersten Ausführungsbeispiel zur Anwendung kommt. Auf der dargestellten Unterseite des Mikrobauteils sind eine Leiterplatte 15, ein erster Kontaktpad 16, ein zweiter Kontaktpad 17 und sechs Programmierpads 18 zu sehen. An den beiden geschnittenen seitlichen Darstellungen ist zu sehen, dass sich auf der Leiterplatte 15 eine Umhüllung 19, ausgebildet als Moldcompound, befindet.

Figur 3 stellt das Mikrobauteil 2 gemäß Figur 2 in Draufsicht dar, wobei die Umhüllung 19 weggelassen wurde, um das Innenleben des Mikrobauteils 2 zu sehen. Somit zeigt Figur 3, wie auf der Leiterplatte 15 ein Sensor 20, ausgebildet als mikroelektromechanischer Sensor zur Beschleunigungsaufnahme, ein anwendungsspezifischer Schaltkreis (ASIC) 21 sowie vier weitere elektronische Bauteile (SMD) 22 angeordnet sind. Der Sensor 20, der anwendungsspezifische Schaltkreis 21 sowie die diversen elektronischen Bauteile 22 sind durch die Umhüllung 19 eingekapselt.

Somit zeigen die Figuren 2 und 3, wie ein beispielhaft zu verwendendes Mikrobauteil 2, ausgebildet als LGA-Gehäuse, verwendet werden kann. Die sehr dünne Leiterplatte 15, trägt das Layout des Mikrobauteils 2 bestehend aus Sensor 20, anwendungsspezifischem Schaltkreis 21 und den diversen passiven elektronischen Bauteilen 22 trägt. All diese Komponenten sind mit einer Moldmasse, dem Überzug 19, in Form eines Epoxidharzes umgeben. Dieses Mikrobauteil 2 wurde innerhalb einer großen Matrix hergestellt. D.h., dass viele dieser Mikrobauteil 2 gleichzeitig hergestellt wurden und durch einen geeigneten Trennprozess wie Sägen oder mittels Laser zu einem Quader geschnitten wurden. Auf der Unterseite der Leiterplatte 15, wie sie in Figur 2 dargestellt ist, welche nicht mit dem Überzug 19 überdeckt ist, befinden sich die typischen zwei Kontaktpads 16 und 17 und sechs Programmierpads 18 zum Programmieren bzw. Testen des Mikrobauteils 2.

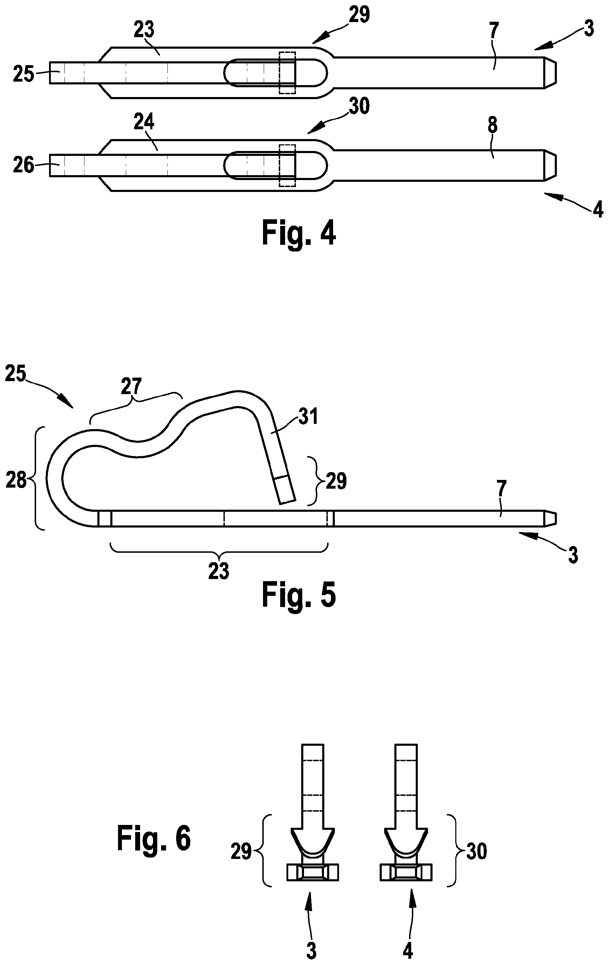

Die Figuren 4, 5 und 6 zeigen das erste Trägerelement 1 und das zweite Trägerelement 2 gemäß dem ersten Ausführungsbeispiel. Dabei zeigt Figur 4 eine Draufsicht und Figur 6 eine Frontansicht. In der Seitenansicht gemäß Figur 5 ist lediglich das erste Trägerelement 3 zu sehen, da sich das zweite Trägerelemente 4 in dieser Ansicht exakt hinter dem ersten Trägerelement 3 befindet und auch diesem ersten Trägerelement 3 exakt entspricht.

Das erste Trägerelement 3 umfasst eine erste Mikrobauteilauflage 23, ein erstes Federelement 25, einen ersten Kontaktfederabschnitt 27, einen ersten Hauptfederabschnitt 28 sowie eine erste Rastvorrichtung 29. In genau gleicher Weise umfasst das zweite Trägerelement 4 eine zweite Mikrobauteilauflage 24, ein zweites Federelement 26 und eine zweite Rastvorrichtung 30. Des Weiteren umfasst das zweite Trägerelement 4 einen zweiten Kontaktfederabschnitt, identisch mit dem ersten Kontaktfederabschnitt 27 sowie einen zweiten Hauptfederabschnitt, identisch mit dem ersten Hauptfederabschnitt 28. Der Übersichtlichkeit halber sind der zweite Kontaktfederabschnitt und der zweite Hauptfederabschnitt nicht dargestellt.

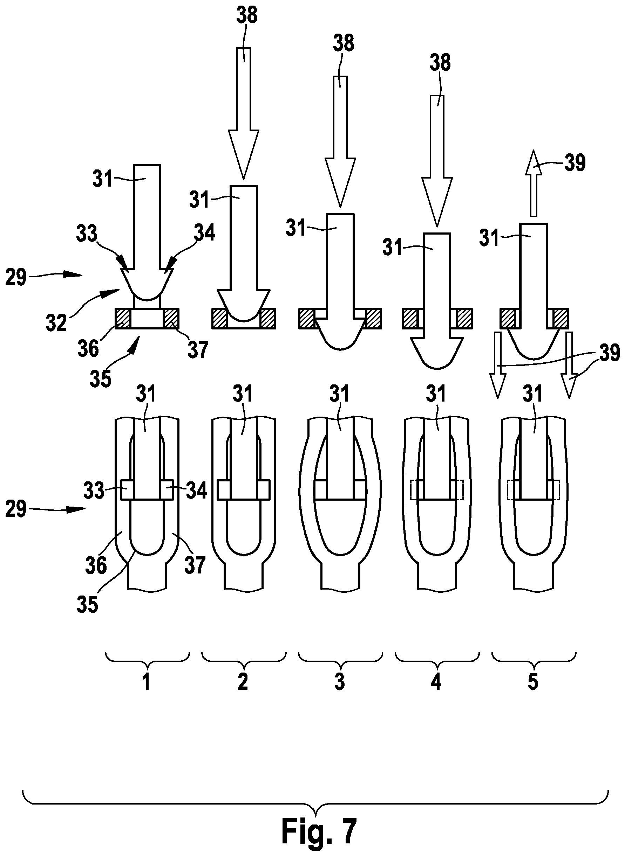

Der erste Anschlusspin 7 des ersten Trägerelementes 3 geht, gemäß Fig.5, direkt über in die erste Mikrobauteilauflage 23. Die erste Mikrobauteilauflage 23 geht in den ersten Hauptfederabschnitt 28 über. Dieser erste Hauptfederabschnitt 28 ist ein mit ausreichendem Radius gebogener Anteil des ersten Trägerelementes 3, wobei das erste Trägerelement 3 am ersten Hauptfederabschnitt 28 derart gebogen ist, dass die durch die Biegung entstehende Federkraft den ersten Kontaktfederabschnitt 27 von der ersten Mikrobauteilauflage 23 beabstandet. Der erste Hauptfederabschnitt 28 geht direkt über in den bogenförmig gebogenen ersten Kontaktfederabschnitt 27. Dieser erste Kontaktfederabschnitt 27 ist durch seine bogenförmige Ausgestaltung der ersten Mikrobauteilauflage 23 zugewandt. Dieser erste Kontaktfederabschnitt 27 geht wiederum mit einer Biegung um 90° in einen Rastnasenverbindungsfortsatz 31 über. Am Ende dieses Rastnasenverbindungsfortsatzes 31 ist ein Rastpfeil 23 ausgebildet. Der exakte Aufbau der ersten Rastverbindung 29 und zweiten Rastverbindung 30 wird anhand Figur 7 im Folgenden beschrieben. Der soeben genau beschriebene Aufbau des ersten Trägerelementes 3 trifft in exakt gleicher Weise auf das zweite Trägerelement 4 zu.

Figur 7 zeigt den Aufbau und den schematischen Ablauf einer Rastverbindung zwischen den Trägerelementen 3, 4 und den Federelementen 25, 26 beispielhaft anhand der ersten Rastvorrichtung 29.

Die erste Rastvorrichtung 29 umfasst den Rastverbindungsfortsatz 31, welcher in den Rastpfeil 32 endet. Dieser Rastpfeil 32 wiederum besteht aus einer ersten Rastnase 33 und einer zweiten Rastnase 34. Diesem Rastpfeil 32 steht in geöffnetem Zustand der Rastvorrichtung 29 eine Rastnut 35, ausgebildet als Rastfeder, gegenüber. Diese Rastnut 35 befindet sich in der ersten Mikrobauteilauflage 23 am Übergang zwischen erster Mikrobauteilauflage 23 und erstem Anschlusspin 7. Die Rastnut 35 ist seitlich begrenzt durch eine erste elastische Wandung 36 und eine zweite elastische Wandung 37. Durch diese beiden elastischen Wandungen 36, 37 ist die Rastnut 35 als eine Rastfeder ausgebildet.

Die Figur 7 zeigt das Einrasten bzw. das Verschließen der Rastvorrichtung 29 in fünf Momentaufnahmen. Die erste Aufnahme zeigt den Ausgangszustand, bevor eine Montagekraft 38 von oben auf den Rastverbindungsfortsatz 31 bzw. von oben auf das erste Federelement 25 wirkt. In der zweiten Aufnahme wird das erste Trägerelement 3 von unten abgestützt, wodurch die Montagekraft 38 von oben aufgebracht werden kann. Der Rastpfeil 32 mit der ersten Rastnase 33 und der zweiten Rastnase 34 ist so ausgestaltet, dass diese in die Rastnut 35 eintauchen können. In der dritten Aufnahme ist gut zu sehen, dass die breiteste Stelle des Rastpfeils 32 breiter ist als die ursprüngliche Breite der Rastnut 35. Deshalb ist es von besonderem Vorteil, dass die Wandungen 36 und 37 der Rastnut 35 elastisch ausgeführt sind und somit eine federnde Wirkung haben. In der Aufnahme 4 ist zu sehen, dass der Rastpfeil 32 soweit durch die Rastnut 35 gedrückt wird, bis die breiteste Stelle des Rastpfeils 32 die Rastnut 35 passiert hat. In diesem Moment federn die elastischen Wandungen 36, 37 wieder in ihre Ausgangslage zurück und halten, wie in Aufnahme 5 gezeigt, die Rastvorrichtung 29 geschlossen. Ein Rückfedern des ersten Federelements 25 aufgrund der Federkraft 39 durch den ersten Hauptfederabschnitt 28 ist Dank dieser geschlossenen ersten Rastverbindung 29 gehemmt.

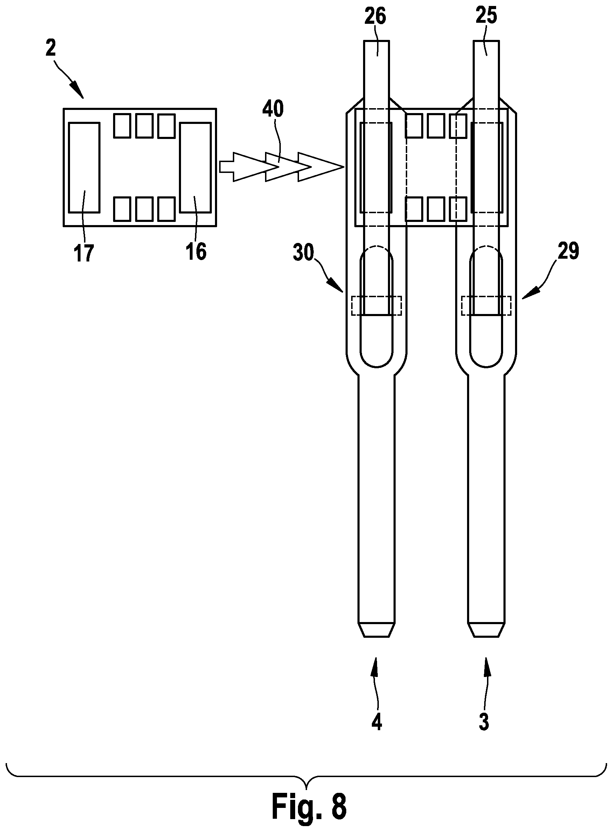

Figur 8 zeigt die Montage des Mikrobauteils 2 in das erste Trägerelement 3 und das zweite Trägerelement 4 gemäß dem ersten Ausführungsbeispiel. Dabei ist gut zu sehen, wie das Mikrobauteil 2 seitlich in die Öffnung zwischen Kontaktfederabschnitt 27, 28 und Mikrobauteilauflage 23, 24 geschoben wird. Dabei werden die Kontaktpads 16, 17 exakt unter den Kontaktfederabschnitten 27, 28 positioniert. Dadurch werden bei Verschließen der Rastvorrichtungen 29, 30 die Kontaktfederabschnitte 27, 28 direkt senkrecht von oben auf die Kontaktpads 16, 17 gedrückt, wodurch eine Beschädigung in Form von Kratzern oder spanabhebendem Reiben an den Kontaktpads 16, 17 vermieden wird. Die Pfeile 40 zeigen diese erste Montagerichtung in Figur 8 an.

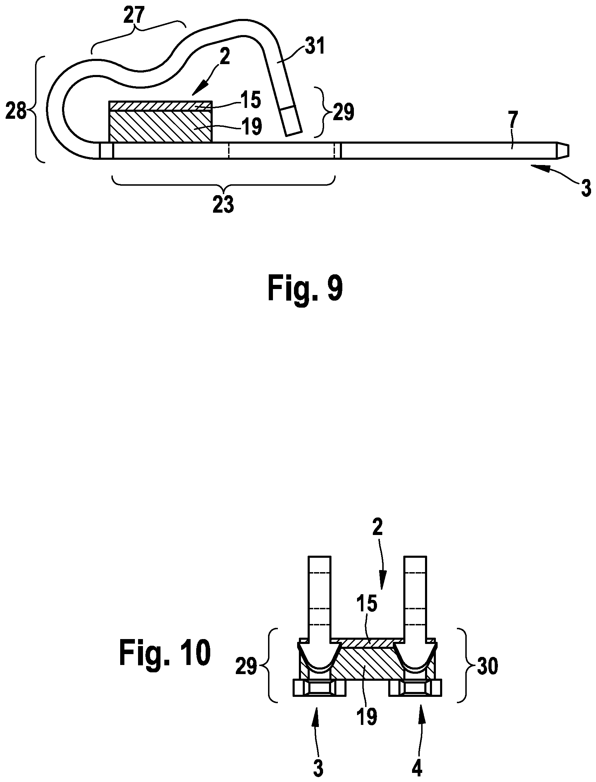

Die Figuren 9 und 10 zeigen die beiden Trägerelemente 3, 4 nach dem ersten Ausführungsbeispiel mit positioniertem Mikrobauteil 2 mit noch offener erster Rastvorrichtung 29 und zweiter Rastvorrichtung 30.

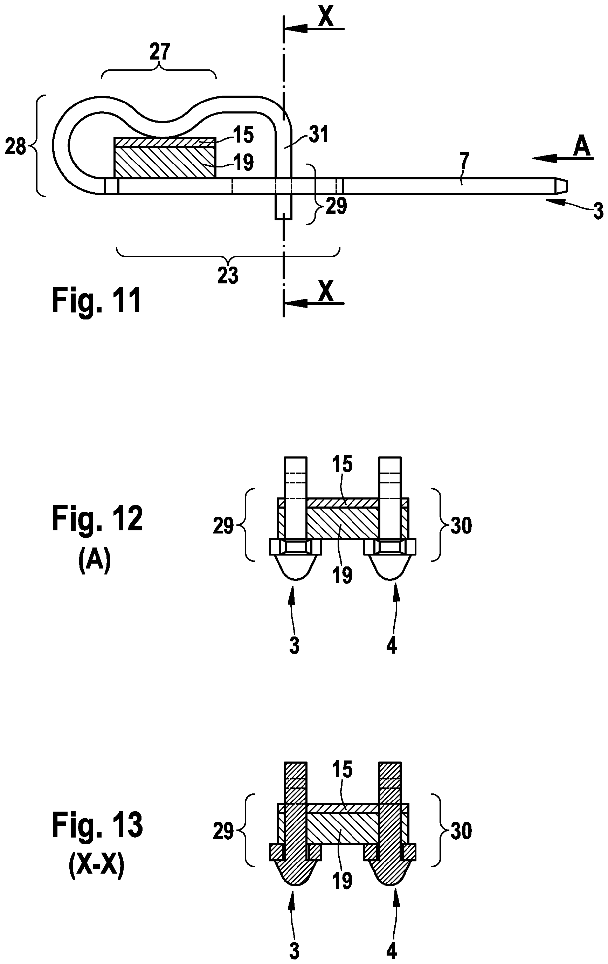

Die Figuren 11, 12 und 13 zeigen das erste Trägerelement 3 und zweite Trägerelement 4 mit montiertem Mikrobauteil 2 und geschlossener erster Rastvorrichtung 29 und geschlossener zweiter Rastvorrichtung 30 nach dem ersten Ausführungsbeispiel. In Figur 11 ist mit X-X der Schnitt aus Figur 13 angedeutet. Der Pfeil A in Figur 11 zeigt die Blickrichtung der Ansicht gemäß Figur 12. Die Figur 11 zeigt, wie der erste Kontaktfederabschnitt 27 das Mikrobauteil 2 sowohl klemmt als auch kontaktiert.

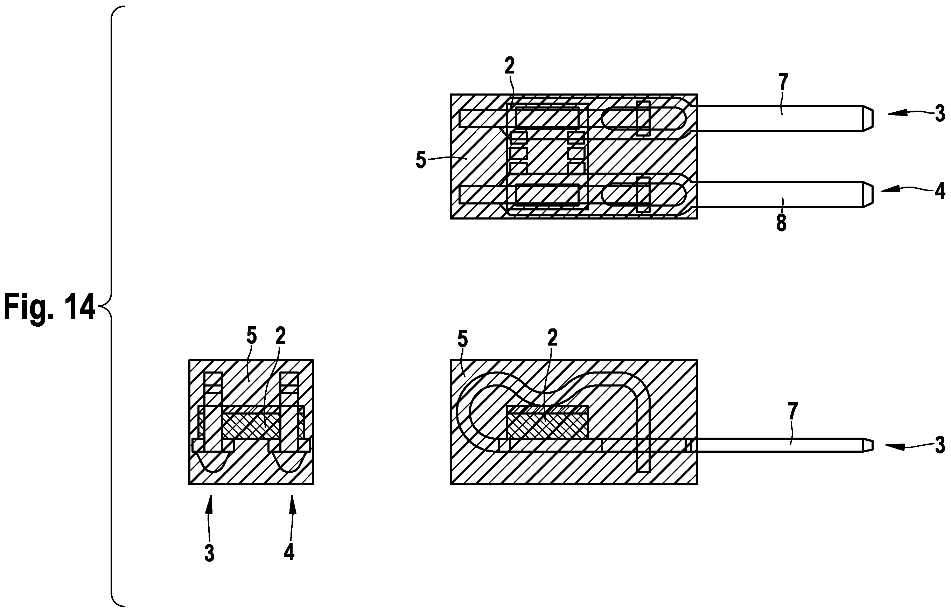

Figur 14 zeigt in drei verschiedenen Ansichten das erste Trägerelement 3 und das zweite Trägerelement 4 mit montiertem Mikrobauteil 2 und geschlossener erster Rastvorrichtung 29 und geschlossener zweiter Rastvorrichtung 30. Des Weiteren wurde in einer Spritzgießmaschine der erste Kunststoffüberzug 5 aufgebracht. Dieser erste Kunststoffüberzug 5 dient zur mechanischen Fixierung des geklemmten Mikrobauteils 2 auf den Trägerelementen 3, 4 und zur Entkoppelung des Stresses beim nachfolgenden Spritzgießprozess des zweiten Kunststoffüberzuges 6. Für den ersten Kunststoffüberzug 5 wurde dabei ein teilflexibles Material, nämlich Silikon, gewählt.

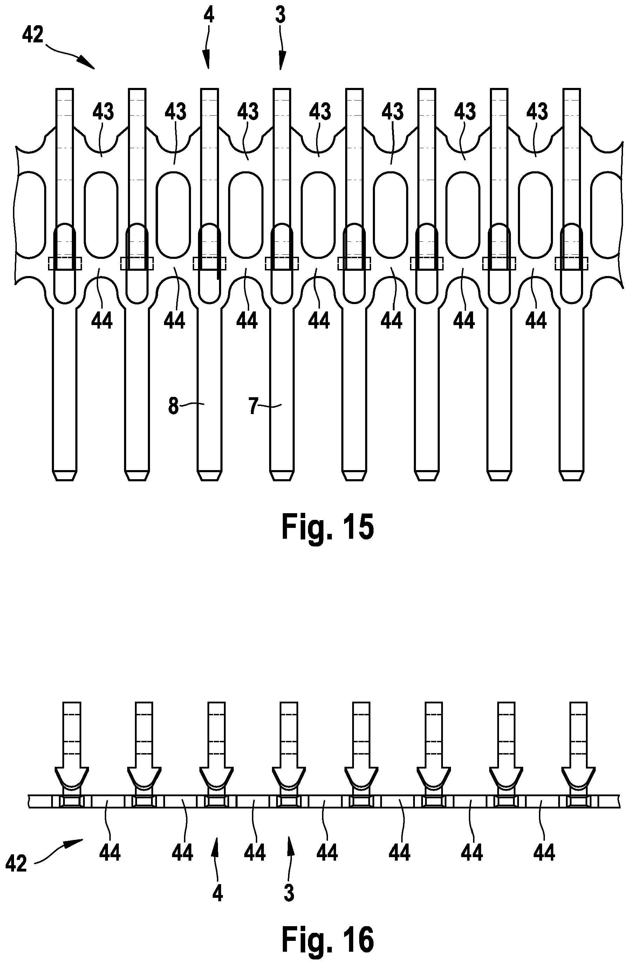

Die Figuren 15 und 16 zeigen ein Blechstanzband 42 zur Herstellung der Trägerelemente 3, 4 gemäß dem ersten Ausführungsbeispiel in Draufsicht und Frontansicht. Dabei ist gut zu sehen, wie diverse Trägerelemente 3, 4 in dem Blechstanzband 42 nebeneinander angeordnet sind. Zur Vereinzelung der Trägerelemente 3, 4 werden abstanzbare Verbindungsbereiche 43, 44 in einem Stanzprozess entfernt. Vor dem Vereinzeln der Trägerelemente 3, 4 wird ein Bandgalvanik-Prozess durchlaufen.

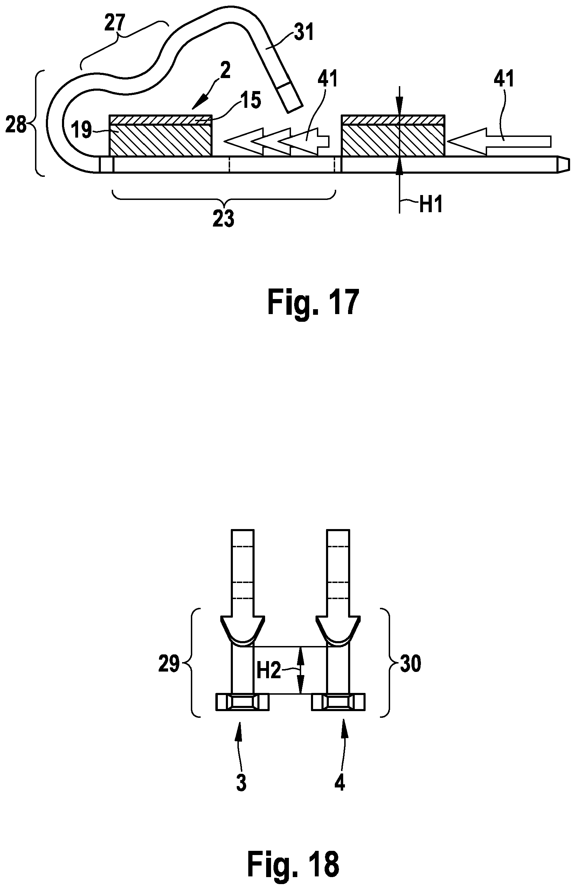

Die Figuren 17 und 18 zeigen ein zweites Ausführungsbeispiel des elektronischen Bauteils 1. Dabei sind gleiche bzw. funktional gleiche Teile mit den gleichen Bezugszeichen wie im ersten Ausführungsbeispiel bezeichnet. Des Weiteren entspricht das zweite Ausführungsbeispiel exakt dem ersten Ausführungsbeispiel mit Ausnahme des Unterschiedes, dass der Rastpfeil 32 im zweiten Ausführungsbeispiel weiter entfernt ist von der Rastnut 35 als im ersten Ausführungsbeispiel im geöffneten Zustand der Rastvorrichtungen 29, 30. Dies hat zur Folge, dass das Mikrobauteil 2 gemäß einer zweiten Montagerichtung 41, dargestellt in Figur 17, zwischen Rastpfeil 32 und Rastnut 35 hindurch auf die Mikrobauteilauflage 23 geschoben bzw. montiert werden kann. Hierzu ist selbstverständlich eine erste Höhe H1 des Mikrobauteils 2 kleiner einer zweiten Höhe H2, wobei die zweite Höhe H2 die lichte Weite zwischen Rastpfeil 32 und Rastnut 35 bzw. Mikrobauteilauflage 23 ist.

Die beiden Ausführungsbeispiele zeigen also, wie das erfindungsgemäße elektronische Bauteil 1 vorteilhafterweise zu gestalten ist. Dabei wurde insbesondere auch klar, wie das erfindungsgemäße Verfahren zu verlaufen hat und welche vorteilhafte Rolle das Blechstanzband 42 bei der Herstellung der Trägerelemente 3, 4 spielt. Das dargestellte elektronische Bauteil 1 ermöglicht es ohne thermische Verbindungsprozesse und ohne Risiko durch metallisch leitende Partikel oder Späne, das Mikrobauteil 2 mit den Trägerelementen 3, 4 zu verbinden und zu kontaktieren. Dabei wurde auch eine ausreichende Kontaktkraft mittels der Kontaktfederabschnitte auf die Kontaktpads 16, 17 aufgebracht, so dass sowohl die mechanische als auch elektrische/elektronische Verbindung zwischen Mikrobauteil 2 und Trägerelementen 3, 4 unter den Rahmenbedingungen des Spritzgießprozesses als auch über die gesamte Lebenszeit des elektronischen Bauteils 1 sicher funktioniert.

## Patentansprüche

1. Elektronisches Bauteil (1) umfassend zumindest ein Mikrobauteil (2) elektrisch kontaktiert und befestigt auf einem Trägerelement (3, 4),
wobei das Trägerelement (3, 4) ein zur Befestigung des zumindest einen Mikrobauteils (2) ausgebildetes Federelement (25, 26) umfasst, und
wobei das Federelement (25, 26) mittels einer Rastvorrichtung (29, 30) im Trägerelement (3, 4) eingerastet ist, um das zumindest eine Mikrobauteil (2) auf dem Trägerelement (3, 4) zu befestigen, wobei das Federelement (25, 26) einen Kontaktfederabschnitt (27) umfasst, welcher zum elektrischen Kontaktieren des Mikrobauteils (2) und des Trägerelements (3, 4) ausgebildet ist, **dadurch gekennzeichnet, dass** das Trägerelement (3, 4) eine Mikrobauteilauflage (23, 24) umfasst, wobei die Mikrobauteilauflage (23, 24) in einen Hauptfederabschnitt (28) des Federelements (25,26) übergeht, wobei der Hauptfederabschnitt (28) in den Kontaktfederabschnitt (27) übergeht, wobei das Federelement (25,26) mit zumindest einer Rastnase (33, 34) der Rastvorrichtung (29, 30) endet, und wobei an der Mikrobauteilauflage (23, 24) eine Rastnut (35) der Rastvorrichtung (29, 30) ausgebildet ist.

2. Elektronisches Bauteil nach Anspruch 1, **dadurch gekennzeichnet, dass** das Trägerelement (3, 4) und das Federelement (25, 26) integral, insbesondere aus gebogenem Blech, gefertigt sind.

3. Elektronisches Bauteil nach Anspruch 1, **dadurch gekennzeichnet, dass** das Trägerelement (3, 4) zum Einsetzen des Mikrobauteils (2) zwischen den Kontaktfederabschnitt (27) und der Mikrobauteilauflage (23, 24) ausgebildet ist, wobei der Kontaktfederabschnitt (27) bogenförmig in Richtung der Mikrobauteilauflage (23, 24) ausgebildet ist.

4. Elektronisches Bauteil nach einem der Ansprüche 1 oder 3, **dadurch gekennzeichnet, dass** zumindest eine Wandung (36, 37) der Rastnut (35) und/oder die Rastnase (33, 34) elastisch verformbar sind.

5. Elektronisches Bauteil nach einem der vorhergehenden Ansprüche, **gekennzeichnet durch** zwei voneinander getrennte Trägerelemente (3, 4), wobei jedes der Trägerelemente (3, 4) ein Federelement (25, 26) und eine Rastvorrichtung (29, 30) umfasst, um das Mikrobauteil (2) mittels beider Trägerelemente (3, 4) zu befestigen und zu kontaktieren.

6. Elektronisches Bauteil nach Anspruch 5, **dadurch gekennzeichnet, dass** das Mikrobauteil (2) zwei Kontaktpads (16, 17) umfasst, welche über je einen Kontaktfederabschnitt (27) mit einem am Trägerelement (3, 4) ausgebildeten Anschlusspin (7, 8) verbunden sind.

7. Elektronisches Bauteil nach einem der vorhergehenden Ansprüche, **gekennzeichnet durch** einen ersten Kunststoffüberzug (5) und einen zweiten Kunststoffüberzug (6), wobei der erste Kunststoffüberzug (5) das Mikrobauteil (2) mit zumindest einem Teil des Trägerelements (3, 4) einkapselt, und wobei am zweiten Kunststoffüberzug (6) Schnittstellen zur Anbindung des elektronischen Bauteils ausgebildet sind.

8. Sensor zur Anwendung in einem Kraftfahrzeug umfassend ein elektronisches Bauteil (1) nach einem der vorhergehenden Ansprüche, wobei das Mikrobauelement (2) einen mikroelektromechanischen Sensor (20) umfasst.

9. Verfahren zur Herstellung eines elektronischen Bauteils nach einem der Ansprüche 1 bis 7, insbesondere eines Sensors zur Anwendung in einem Kraftfahrzeug, umfassend die Schritte:
- Bereitstellen des Trägerelements (3, 4) mit dem zur Befestigung zumindest eines Mikrobauteils ausgebildeten Federelement (25, 26),
- Einsetzen des zumindest einen Mikrobauteils (2) zwischen den Kontaktfederabschnitt (27) des Federelements (25, 26) und die Mikrobauteilauflage (23, 24) des Trägerelements (3, 4),
- Schließen des Federelements (25, 26) entgegen einer Federkraft, und
- Einrasten der Rastvorrichtung (29, 30) zwischen Federelement (25, 26) und Trägerelement (3, 4).

## Claims

1. Electronic component (1) comprising at least one microcomponent (2) which is electrically contact-connected and mounted on a carrier element (3, 4), wherein the carrier element (3, 4) comprises a spring element (25, 26) which is designed for mounting the at least one microcomponent (2), and wherein the spring element (25, 26) is latched into the carrier element (3, 4) by means of a latching apparatus (29, 30) in order to mount the at least one microcomponent (2) on the carrier element (3, 4), wherein the spring element (25, 26) comprises a contact spring section (27) which is designed for electrically contact-connecting the microcomponent (2) and the carrier element (3, 4), **characterized in that** the carrier element (3, 4) comprises a microcomponent support (23, 24), wherein the microcomponent support (23, 24) merges with a main spring section (28) of the spring element (25, 26), wherein the main spring section (28) merges with the contact spring section (27), wherein the spring element (25, 26) ends with at least one latching lug (33, 34) of the latching apparatus (29, 30), and wherein a latching groove (35) of the latching apparatus (29, 30) is formed on the microcomponent support (23, 24).

2. Electronic component according to Claim 1, **characterized in that** the carrier element (3, 4) and the spring element (25, 26) are integrally produced, in particular from bent sheet metal.

3. Electronic component according to Claim 1, **characterized in that** the carrier element (3, 4) is designed for inserting the microcomponent (2) between the contact spring section (27) and the microcomponent support (23, 24), wherein the contact spring section (27) is designed in the form of an arc in the direction of the microcomponent support (23, 24).

4. Electronic component according to one of Claims 1 and 3, **characterized in that** at least one wall (36, 37) of the latching groove (35) and/or the latching lug (33, 34) are/is elastically deformable.

5. Electronic component according to one of the preceding claims, **characterized by** two carrier elements (3, 4) which are separated from one another, wherein each of the carrier elements (3, 4) comprises a spring element (25, 26) and a latching apparatus (29, 30) in order to mount and contact-connect the microcomponent (2) by means of both carrier elements (3, 4).

6. Electronic component according to Claim 5, **characterized in that** the microcomponent (2) comprises two contact pads (16, 17) which are connected to a connection pin (7, 8), which is formed on the carrier element (3, 4), by means of a contact spring section (27) in each case.

7. Electronic component according to one of the preceding claims, **characterized by** a first plastic coating (5) and a second plastic coating (6), wherein the first plastic coating (5) encapsulates the microcomponent (2) with at least one part of the carrier element (3, 4), and wherein interfaces for connecting the electronic component are formed on the second plastic coating (6).

8. Sensor for use in a motor vehicle, comprising an electronic component (1) according to one of the preceding claims, wherein the microcomponent (2) comprises a microelectromechanical sensor (20).

9. Method for producing an electronic component according to one of Claims 1 to 7, in particular a sensor for use in a motor vehicle, comprising the steps of:
- providing the carrier element (3, 4) with the spring element (25, 26) which is designed for mounting at least one microcomponent,
- inserting the at least one microcomponent (2) between the contact spring section (27) of the spring element (25, 26) and the microcomponent support (23, 24) of the carrier element (3, 4),
- closing the spring element (25, 26) against a spring force, and
- latching in the latching apparatus (29, 30) between spring element (25, 26) and carrier element (3, 4).

## Revendications

1. Composant électronique (1) comprenant au moins un microcomposant (2) mis en contact électrique avec un élément de support (3, 4) et fixé à celui-ci, dans lequel l'élément de support (3, 4) comprend un élément à ressort (25, 26) réalisé pour fixer l'au moins un microcomposant (2), et dans lequel l'élément à ressort (25, 26) est encliqueté dans l'élément de support (3, 4) au moyen d'un dispositif d'encliquetage (29, 30), afin de fixer l'au moins un microcomposant (2) sur l'élément de support (3, 4), dans lequel l'élément à ressort (25, 26) comprend une section à ressort de contact (27), qui est réalisée pour mettre en contact électrique le microcomposant (2) et l'élément de support (3, 4), **caractérisé en ce que** l'élément de support (3, 4) comprend une surface d'appui de microcomposant (23, 24), dans lequel la surface d'appui de microcomposant (23, 24) de l'élément à ressort (25, 26) dépasse dans une section à ressort principale (28), dans lequel la section à ressort principale (28) dépasse dans la section à ressort de contact (27), dans lequel l'élément à ressort (25, 26) se termine par au moins un ergot d'encliquetage (33, 34) du dispositif d'encliquetage (29, 30), et dans lequel une rainure d'encliquetage (35) du dispositif d'encliquetage (29, 30) est réalisée sur la surface d'appui de microcomposant (23, 24).

2. Composant électronique selon la revendication 1, **caractérisé en ce que** l'élément de support (3, 4) et l'élément à ressort (25, 26) sont fabriqués de manière solidaire, notamment à partir d'une tôle coudée.

3. Composant électronique selon la revendication 1, **caractérisé en ce que** l'élément de support (3, 4) est réalisé de manière à installer le microcomposant (2) entre la section à ressort de contact (27) et la surface d'appui de microcomposant (23, 24), dans lequel la section à ressort de contact (27) est réalisée sous forme arquée dans la direction la surface d'appui de microcomposant (23, 24).

4. Composant électronique selon les revendications 1 ou 3, **caractérisé en ce qu'**au moins une cloison (36, 37) de la rainure d'encliquetage (35) et/ou l'ergot d'encliquetage (33, 34) peuvent être déformés élastiquement.

5. Composant électronique selon l'une quelconque des revendications précédentes, **caractérisé par** deux éléments de support (3, 4) séparés l'un de l'autre, dans lequel chacun des éléments de support (3, 4) comprend un élément à ressort (25, 26) et un dispositif d'encliquetage (29, 30) pour fixer et mettre en contact le microcomposant (2) au moyen des deux éléments de support (3, 4).

6. Composant électronique selon la revendication 5, **caractérisé en ce que** le microcomposant (2) comprend deux plots de contact (16, 17) qui sont respectivement reliés par l'intermédiaire d'une section à ressort de contact (27) à une broche de raccordement (7, 8) réalisée sur l'élément de support (3, 4).

7. Composant électronique selon l'une quelconque des revendications précédentes, **caractérisé par** un premier revêtement en matière plastique (5) et un deuxième revêtement en matière plastique (6), dans lequel le premier revêtement en matière plastique (5) encapsule le microcomposant (2) avec au moins une partie de l'élément de support (3, 4), et dans lequel des interfaces de jonction du composant électronique sont réalisées sur le deuxième revêtement en matière plastique (6).

8. Capteur destiné à être utilisé dans un véhicule automobile comprenant un composant électronique (1) selon l'une quelconque des revendications précédentes, dans lequel le microcomposant (2) comprend un capteur microélectromécanique (20).

9. Procédé de fabrication d'un composant électronique selon l'une quelconque des revendications 1 à 7, notamment d'un capteur destiné à être utilisé dans un véhicule automobile, comprenant les étapes consistant à :
- fournir l'élément de support (3, 4) avec l'élément à ressort (25, 26) réalisé de manière à fixer au moins un microcomposant,
- installer l'au moins un microcomposant (2) entre la section à ressort de contact (27) de l'élément à ressort (25, 26) et la surface d'appui de microcomposant (23, 24) de l'élément de support (3, 4),
- fermer l'élément à ressort (25, 26) en s'opposant à une force de ressort, et
- encliqueter le dispositif d'encliquetage (29, 30) entre l'élément à ressort (25, 26) et l'élément de support (3, 4).
